# EUROPÄISCHE PATENTSCHRIFT

(11) **EP 2 409 552 B1**
(45) Veröffentlichungstag und Bekanntmachung des Hinweises auf die Patenterteilung: **21.02.2018**
(21) Anmeldenummer: 10711044.7
(22) Anmeldetag: 18.03.2010
(51) Int. Cl.: H05B 41/392, H03M 1/18

(54) **SCHALTUNG UND BELEUCHTUNGSSYSTEM ZUM DIMMEN EINES LEUCHTMITTELS**
CIRCUIT AND LIGHTING SYSTEM FOR DIMMING OF A LIGHT SOURCE
CIRCUIT ET SYSTEME POUR REGULATION D'UN SOURCE LUMINEUSE

(30) Priorität: 19.03.2009 DE 102009013897
(43) Veröffentlichungstag der Anmeldung: 25.01.2012
(73) Patentinhaber: Tridonic GmbH & Co KG, 6851 Dornbirn (AT)
(72) Erfinder: KNOEDGEN, Horst, 80997 München (DE)
(74) Vertreter: Rupp, Christian
(86) Internationale Anmeldenummer: PCT/EP2010/053522
(87) Internationale Veröffentlichungsnummer: WO 2010/106128

(56) Entgegenhaltungen:
- US-A1- 2005 174 274
- US-A1- 2005 179 404
- US-A1- 2007 188 111
- US-A1- 2008 042 632
- David M Alter: "Using PWM Output as a Digital-to-Analog Converter on a TMS320F280x Digital Signal Controller", , 30 September 2008 (2008-09-30), pages 1-32, XP055111723, Retrieved from the Internet: URL:http://www.ti.com/lit/an/spraa88a/spra a88a.pdf [retrieved on 2014-04-02]

## Beschreibung

Die Erfindung betrifft ein Verfahren zum geregelten Dimmen eines Leuchtmittels, wie bspw. LED, OLEDs oder Gasentladungslampen entsprechend Sollwerte bildenden digitalen Dimmwerten.

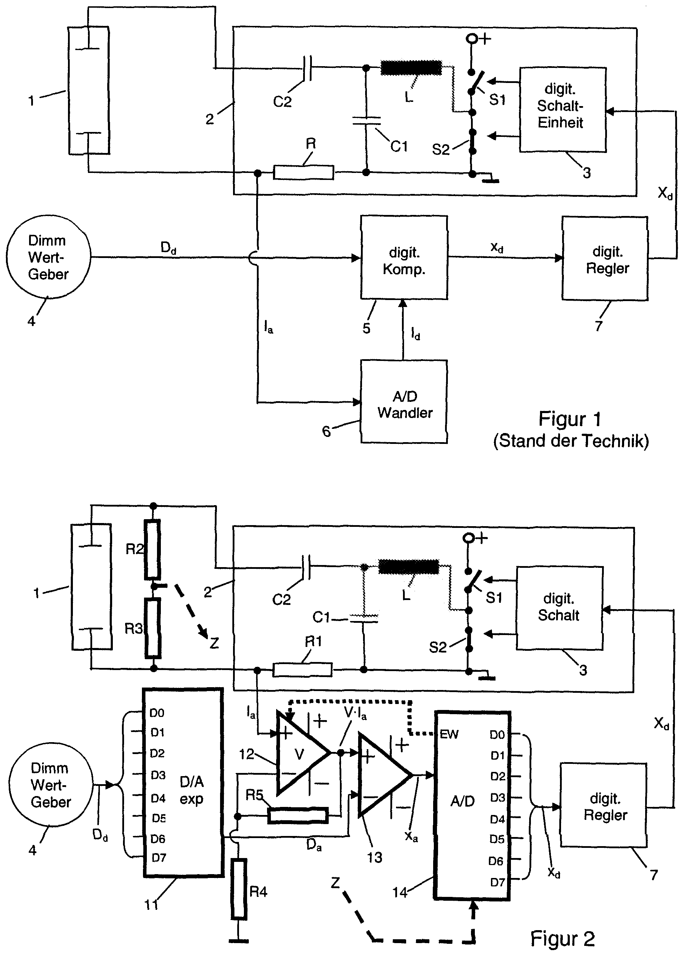

Ein derartiges Verfahren ist bekannt und wird beispielsweise mit der in Figur 1 dargestellten Schaltungsanordnung nach dem Stand der Technik ausgeführt. Bei der bekannten Schaltungsanordnung ist das Leuchtmittel eine Gasentladungslampe 1. Diese wird mit einem Vorschaltgerät 2 betrieben, dass in bekannter Weise ausgeführt ist und aus diesem Grund sind nur die wesentlichen Bauelemente in schematischer Form dargestellt. Das Vorschaltgerät 2 enthält zwei in Serie geschaltete elektronische Schalter S1, S2, die mit einer Betriebsgleichspannung versorgt werden. Die beiden Schalter S1, S2 werden von einer digitalen Schalteinheit 3 gesteuert, die die Schaltfrequenz und/oder das Taktverhältnis ändern kann. Über dem unteren Schalter S2 liegt ein aus einer Induktivität L und einem Resonanzkondensator C1 gebildeter Serienresonanzkreis. Der Spannungsabfall über dem Resonanzkondensator C1 wird über einen Koppelkondensator C2 der Lampe 1 zugeführt. Im Stromkreis der Lampe liegt ein Widerstand R1. Der Spannungsabfall über dem Widerstand R1 ist ein Maß für die von der Lampe 1 erzeugte Lichtstärke und kann daher zur Bildung analoger Istwerte Iₐ verwendet werden. Das Dimmen der Lampe 1 erfolgt über einen digitalen Regelkreis. Von einem Dimmwertgeber 4, der in einer entfernten Zentrale angeordnet sein kann, werden beispielsweise über einen DALI-Bus digitale Dimmwerte D_{d} zur Verfügung gestellt. Um eine möglichst feine Auflösung der Dimmstufen zu gewährleisten, können die digitalen Dimmwerte beispielsweise von 12 oder 13 bits gebildet sein. Die oben erwähnten analogen Istwerte Iₐ werden in einem A/D-Wandler 6 in digitale Istwerte I_{d} umgewandelt. Die digitalen Dimmwerte D_{d} und die digitalen Istwerte I_{d} werden in einem digitalen Komparator 5 miteinander verglichen. Für den Vergleich sollte der A/D-Wandler 6 möglichst die gleiche bit-Zahl haben wie die digitalen Dimmwerte D_{d}. Das hat bei einer höheren bit-Zahl von - wie vorstehend erwähnt - beispielsweise 12 oder 13 bits zur Folge, dass der A/D-Wandler 6 relativ langsam arbeitet. Der digitale Komparator 5 erzeugt durch den Vergleich der digitalen Dimmwerte D_{d} und der digitalen Istwerte I_{d} eine digitale Regelabweichung x_{d}, die einem digitalen Regler 7 zugeführt wird. Der digitale Regler 7 erzeugt daraus einen digitalen Stellwert X_{d}, welcher dann der digitalen Schaltereinheit 3 zugeführt wird.

Da der A/D-Wandler 6, wie vorstehend erwähnt, relativ langsam ist, arbeitet er im Bereich von Millisekunden. Das hat zur Folge, dass der gesamte Regelkreis relativ langsam ist.

US 2007/188111 A1 offenbart eine elektronische Last zum Ansteuern einer Gasentladungslampe. Für die Ansteuerung werden digitale Dimmwerte in analoge Dimmwerte umgewandelt, die analogen Dimmwerte mit entsprechenden analogen Istwerten verglichen und daraus eine analoge Regelabweichung ermittelt. Die analoge Regelabweichung wird dann in eine digitale Regelabweichung zur Durchführung der digitalen Regelung umgewandelt.

US 2005/174274 A1 offenbart eine gemischte analog-digitale Verstärkungsregelung mit einem analogen Verstärker, einem A/D-Wandler, einer CLAMP-Schaltung zur Erzeugung eines Referenzpegels sowie einer Fehlererfassung mit Rückkopplung des Fehlers.
Der Erfindung liegt die Aufgabe zu Grunde, das eingangs angegebene Verfahren so zu modifizieren, dass die Anforderungen an die verwendeten Bauteile verringert werden.

Insbesondere sollen die Anforderungen an den A/D- Wandler verringert werden.

Zentraler Gedanke der Erfindung ist dabei, nicht unmittelbar eine analoge Rückführgrösse, sondern eine im analogen Bereich ermittelte Regeldifferenz (Regelabweichung) zu digitalisieren, um sie dann in einem digitalen Regelalgorithmus zu verarbeiten, der einen digitale Stellgrösse ermittelt, die die Leistung der Leuchtmittel beeinflusst.

Die Aufgabe ist gemäß dem Kennzeichen des Anspruchs 1dadurch gelöst, dass digital einem Betriebsgerät vorgegebene Dimm-Sollwerte (in folgenden "Dimmwerte" genannt) zunächst in analoge Dimmwerte umgewandelt werden, dass die analogen Dimmwerte mit entsprechenden analogen Istwerten verglichen werden und dass daraus eine analoge Regelabweichung ermitteln wird, und dass die analoge Regelabweichung dann in eine digitale Regelabweichung zur Durchführung der digitalen Regelung umgewandelt wird.

Der Erfindung liegt die Erkenntnis zu Grunde, dass die durch Subtraktion der Istwerte von den Sollwerten (Dimmwerten) gebildete Regeldifferenz geringer ist als die von der Lampe zurückgeführten Istwerte. Bei Verwendung eines PI-Reglers reduziert sich die Regeldifferenz nach dem Einschwingen sogar auf Null. Die relativ geringe analoge Regelabweichung muss zwar anschließend in eine digitale Regelabweichung umgewandelt werden; der dafür erforderliche A/D-Wandler kann jedoch eine verringerte Bit-Zahl haben. Er arbeitet damit schneller als der bisherige A/D-Wandler, mit dem die analogen Istwerte in digitale Istwerte umgewandelt wurden. Damit arbeitet auch der gesamte Regelkreis schneller.

Zwar ist es für das erfindungsgemäße Verfahren notwendig, die digitalen Dimm-Sollwerte zunächst in analoge Dimm-Sollwerte umzuwandeln; der dafür erforderliche D/A-Wandler ist jedoch nicht Teil des Regelkreises und beeinflusst deshalb dessen Regelgeschwindigkeit nicht. Diese kann nach der erfindungsgemäßen Ausführung im Bereich von Mikrosekunden liegen.

Zweckmäßige Weiterbildungen des erfindungsgemäßen Verfahrens sind Gegenstand der Ansprüche 2-5.

Die Erfindung betrifft ferner eine Schaltungsanordnung zum Dimmen eines Leuchtmittels entsprechend - Sollwerte bildenden - digitalen Dimmwerten durch digitale Regelung, mit einem Komparator, dem die Dimmwert und der Helligkeit des Leuchtmittels entsprechende Istwerte zugeführt werden, und der durch Vergleich eine Regelabweichung ermittelt, und mit einem digitalen Regler, dem die Regelabweichung zugeführt wird, und der daraus den analogen Stellwert zur Steuerung des Leuchtmittels erzeugt.

Die vorstehend beschriebene Schaltungsanordnung wurde bereits eingangs als bekannt erwähnt und in Zusammenhang mit Figur 1 erläutert.

Die Aufgabenstellung für die Schaltungsanordnung entspricht derjenigen für das erfindungsgemäße Verfahren.

Die schaltungstechnische Lösung der Aufgabenstellung besteht darin, dass dem Komparator ein D/A-Wandler vorgeschaltet ist, der die digitalen Dimmwerte in analoge Dimmwerte umwandelt, dass der Komparator analog arbeitet und eine analoge Regelabweichung ermittelt, und dass dem Komparator ein A/D-Wandler nachgeschaltet ist, der die analoge Regelabweichung in eine digitale Regelabweichung umwandelt, welche dann dem digitalen Regler zugeführt wird.

Zweckmäßige Ausgestaltungen der erfindungsgemäßen Schaltungsanordnung sind Gegenstand der Ansprüche 7-13.

An dieser Stelle sei bemerkt, dass der nicht zitierte Inhalt der vorstehend erwähnten abhängigen Ansprüche 2-5 und 7-13 Teil der Offenbarung der Beschreibung sein soll.

Die Erfindung betrifft schließlich auch ein Beleuchtungssystem.

Ausführungsbeispiele der Erfindung werden nachfolgend anhand der Zeichnungen beschrieben.

Es zeigen:
Figur 1 eine Schaltungsanordnung nach dem Stand der Technik;
Figur 2 eine Ausführungsform der erfindungsgemäßen Schaltungsanordnung;
Figur 3 die logarithmische Abhängigkeit der subjektiven empfundenen Helligkeit von der physikalisch messbaren Lichtstärke des Leuchtmittels;
Figur 4 die lineare Abhängigkeit der Lichtstärke von linear digitalisierten Dimmwerten;
Figur 5 die Abhängigkeit der analogen Dimmwerte von den digitalen Dimmwerten mit einer gezielten exponentiellen Verzerrung zur Kompensation der logarithmischen Kurve gemäß Figur 1.

Die bekannte Schaltungsanordnung gemäß Figur 1 wurde bereits eingangs im Zusammenhang mit der Beschreibung des Standes der Technik erläutert.

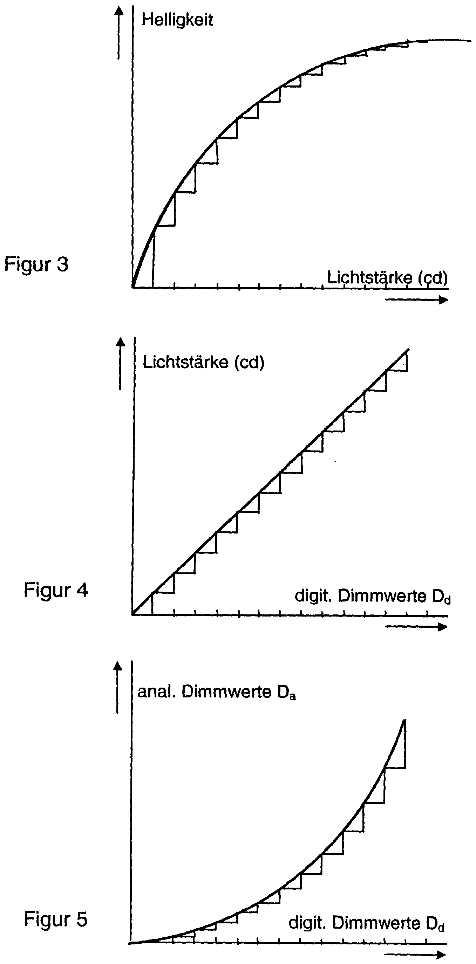

In Figur 2 sind gleiche Bauelemente wie in Figur 1 mit den gleichen Bezugsziffern bezeichnet. Neu hinzugefügte Bauelemente und Blöcke sind in fetten Linien dargestellt. Die Schaltungsanordnung nach Figur 2 weicht zunächst dadurch von derjenigen nach Figur 1 ab, dass die digitalen Dimmwerte D_{d} in einem D/A-Wandler 11 in analoge Dimmwerte Dₐ umgewandelt werden. Die besonderen Eigenschaften des D/A-Wandlers 11 werden später noch in Verbindung mit den Figuren 3-5 erläutert.

Die analogen Dimmwerte Dₐ werden dem Minus-Eingang eines von einem Operationsverstärker gebildeten analogen Komparators 13 zugeführt. Die analogen Istwerte Iₐ werden dem Plus-Eingang eines Operationsverstärkers 12 zugeführt, der einen variablen Verstärkungsgrad V hat. Der Minus-Eingang des Operationsverstärkers 12 liegt über einem Widerstand R4 an Masse; außerdem ist er über einen Rückkopplungswiderstand R5 mit dem Ausgang des Operationsverstärkers 12 verbunden. Am Ausgang des Operationsverstärkers 12 liegen die um V verstärkten analogen Istwert-Signale V*Iₐ an. Sie werden dem Plus-Eingang des Komparators 13 zugeführt. Der Komparator 13 bildet die Differenz aus seinen beiden Eingangssignalen und erzeugt damit die analoge Regelabweichung xₐ. Diese wird einem A/D-Wandler 14 zugeführt. Der A/D-Wandler 14 erzeugt aus der analogen Regelabweichung xₐ eine digitale Regelabweichung x_{d}, die dem digitalen Regler 7 zugeführt wird. Die Verarbeitung der digitalen Regelabweichung x_{d} erfolgt dann wie bei der Schaltungsanordnung nach Figur 1.

Wesentlich ist, dass bei der Schaltungsanordnung nach Figur 2 die digitalen Dimmwerte D_{d} in analoge Dimmwerte Dₐ umgewandelt werden, und dass die verstärkten analogen Istwerte V*Iₐ mit den analogen Dimmwerten Dₐ in einem analog arbeitenden Komparator 13 verglichen werden, um die analoge Regelabweichung xₐ zu erzeugen, wobei letztere dann wieder mit dem A/D-Wandler in eine digitale Regelabweichung x_{d} umgewandelt wird. Im Vergleich zu Figur 1 wird bei der Schaltungsanordnung nach Figur 2 also der A/D-Wandler 6 weggelassen; dafür sind aber der D/A-Wandler 11 und der A/D-Wandler 14 hinzugekommen. Trotz dieses scheinbaren Mehraufwandes hat die Schaltungsanordnung nach Figur 2 einen entscheidenden Vorteil, und zwar den, dass der Regelkreis schneller arbeiten kann. Der A/D-Wandler 14, der Teil des Regelkreises ist, muss nur die relativ geringe analoge Regelabweichung xₐ in eine digitale Regelabweichung x_{d} umwandeln, sodass der mit relativ wenig bits, beispielsweise 8 bits auskommt. Das bedeutet, dass der Regelkreis der Schaltungsanordnung gemäß Figur 2 schneller arbeitet, als derjenige der Schaltungsanordnung nach Figur 1, bei der der A/D-Wandler 6 eine hohe bit-Zahl verarbeiten muss, nämlich diejenige, die in der Regel mit dem digitalen Dimmwert D_{d} vorgegeben wird.

Zur Erläuterung einer Zusatzfunktion des D/A-Wandlers 11 wird nun Bezug genommen auf die Figuren 3-5.

Figur 3 zeigt die bekannte Abhängigkeit der subjektiv empfundenen Helligkeit von der physikalisch - in Candela (cd) messbaren - Lichtstärke eines Leuchtmittels. Man erkennt, dass bei höheren Lichtstärken äquidistante Lichtstärke-Sprünge nur noch als geringe Helligkeits-Sprünge wahrgenommen werden. Bei geringen Lichtstärken werden dagegen äquidistante Lichtstärke-Sprünge als entsprechend hohe Helligkeits-Sprünge wahrgenommen.

Figur 4 zeigt den normalen linearen Zusammenhang zwischen der von einem Leuchtmittel, insbesondere von einer Gasentladungslampe erzeugten Lichtstärke und linear digitalisierten Dimmwerten D_{d}.

Wenn man das Leuchtmittel mit äquidistant linearisierten Dimmwerten D_{d} gemäß Figur 4 steuert, so hat der Beobachter das Helligkeitsempfinden gemäß Figur 3. Die Helligkeits-Sprünge sind in Abhängigkeit von der Lichtstärke stark unterschiedlich. Um über den gesamten Lichtstärkebereich dennoch eine einigermaßen zufriedenstellende Helligkeits-Auflösung zu erzielen, muss der D/A-Wandler 11 eine relativ hohe bit-Zahl, beispielsweise 13 oder 14 bits haben. Das ist zwar hinsichtlich der verringerten Schnelligkeit beim Dimmen kein Problem; wünschenswert ist nur eine schnelle Regelung. Jedoch ist ein derartiger D/A-Wandler teurer als ein D/A-Wandler mit geringerer bit-Zahl.

Man kann einen D/A-Wandler mit geringerer bit-Zahl verwenden, wenn man einen solchen wählt, der zusätzlich exponentiell verzerrt, wie dies in Figur 5 dargestellt ist. Die Verzerrung bedeutet, dass für linearisierte digitale Dimmwerte D_{d} analoge Dimmwerte Dₐ erzeugt werden, die bei höheren Dimmwerten größer und bei geringeren Dimmwerten kleiner sind. Auf diese Weise wird die logarithmische Kurve gemäß Figur 3 durch die exponentielle Kurve gemäß Figur 5 kompensiert.

Ein solcher exponentiell verzerrender D/A-Wandler 11 ist bei der Schaltungsanordnung gemäß Figur 2 verwendet. Er kommt mit 8 bits aus. Dementsprechend hat er auch 8 bit-Eingänge. Ein derartig verzerrender D/A-Wandler ist nicht zwingend erforderlich, aber aus den beschriebenen Gründen vorteilhaft. An seiner Stelle kann auch ein linear umsetzender D/A-Wandler mit höherer bit-Zahl verwendet werden, der dann aber - wie erwähnt - kostenmäßig ungünstiger ist.

Wie oben beschrieben, ist der Verstärkungsgrad V des Operationsverstärkers 12 variabel. Der Verstärkungsgrad V kann reduziert werden, wenn der A/D-Wandler 14 an seinen Extremwert kommt, d.h. an seine Grenze stößt. In diesem Fall wird beispielsweise der Verstärkungsgrad V des Operationsverstärkers 12 auf die Hälfte reduziert. Zur Kompensation muss dann in dem A/D-Wandler 14 dem Digitalbereich eine Multiplikation um das Doppelte vorgenommen werden. Die Meldung des Erreichens des Extremwertes EW ist durch die dicke punktierte Linie zwischen dem A/D-Wandler 14 und dem Operationsverstärker 12 angedeutet. Die Verringerung des Verstärkungsgrades V des Operationsverstärkers 12 erfolgt praktischerweise mit einem Faktor, der sich aus einer Binärkombination ergibt, also 2, 4, 8, usw. Damit die letztgenannte Funktion ausgelöst wird, müssen sehr hohe Regelabweichungen xₐ auftreten, und es muss in diesem Fall in Kauf genommen werden, dass die Multiplikation im Digitalbereich eine Verschlechterung der Auflösung zur Folge hat.

Die Verringerung des Verstärkungsgrades V des Operationsverstärkers 12 kann auch bei einem anderen Betriebszustand ausgelöst werden, beispielsweise dann, wenn die Lampe 1 gezündet hat oder kurz danach, wenn das Regelsystem eingeschwungen ist. Erst dann nämlich ist eine feine Auflösung wünschenswert. Die Möglichkeit, dass der Verstärkungsgrad V reduziert wird, wenn die Zündung der Lampe 1 erfolgt ist, ist in Figur 2 durch die dicke gestrichelte Linie angedeutet, die von dem Knotenpunkt eines über der Lampe 1 liegenden Spannungsteilers R2/R3 über die Strecke Z-Z zu dem A/D-Wandler 14 führt. Die von dem Spannungsteiler R1/R2 abgenommene Signalspannung Z entspricht der Lampenspannung, die sich nach der Zündung verändert.

Es besteht weiterhin die Möglichkeit, dass dem Operationsverstärker 12 eine Vorab-Information über einen sich anbahnenden größeren Dimmsprung übermittelt wird. Ferner ist es möglich, dass EVG 2 so zu modifizieren, dass es einen großen Dimmsprung erst dann ausführt, wenn der Operationsverstärker 12 seinen Verstärkungsgrad V reduziert und die Reduktion durch Multiplikation im Digitalbereich in dem A/D-Wandler 14 kompensiert worden ist.

## Patentansprüche

1. Verfahren zum Dimmen eines Leuchtmittels (1) entsprechend - Sollwerte bildenden - digitalen Dimmwerten (D_{d}) durch digitale Regelung (7), wobei die digitalen Dimmwerte (D_{d}) zunächst in analoge Dimmwerte (Dₐ) umgewandelt werden, wobei die analogen Dimmwerte (Dₐ) mit entsprechenden analogen Istwerten (Iₐ) verglichen (13) werden und dass daraus eine analoge Regelabweichung (xₐ) ermitteln wird, und wobei die analoge Regelabweichung (xₐ) in eine digitale Regelabweichung (x_{d}) zur Durchführung der digitalen Regelung (7) umgewandelt wird,
**dadurch gekennzeichnet,**
**dass** die analogen Istwerte (Iₐ) vor dem Vergleich mit den analogen Dimmwerten (Dₐ) verstärkt (V) werden.

2. Verfahren nach Anspruch 1
**dadurch gekennzeichnet,**
**dass** die digitalen Dimmwerte (D_{d}) bei Umwandlung in analoge Dimmwerte (Dₐ) so modifiziert werden, dass die Dimmwert-Schritte bei hohen Dimmwerten größer sind als bei geringen Dimmwerten.

3. Verfahren nach Anspruch 1 oder 2
**dadurch gekennzeichnet,**
**dass** der Verstärkungsgrad (V) bei Erreichen eines bestimmten Betriebszustandes um einen Faktor reduziert wird,
und **dass** zur Kompensation der Reduzierung bei der D/A-Umwandlung eine Multiplikation mit diesem Faktor vorgenommen wird.

4. Verfahren nach Anspruch 3
**dadurch gekennzeichnet,**
**dass** der Faktor einer Binärkombination entspricht, also 2, 4, 8 usw.

5. Verfahren nach Anspruch 3 oder 4,
**dadurch gekennzeichnet,**
**dass** der bestimmte Betriebszustand das Erreichen eines Extremwertes bei der A/D-Umwandlung und/oder - falls das Leuchtmittel (1) eine Gasentladungslampe ist - das Zünden der Gasentladungslampe ist, letzteres ggf. mit Verzögerung bis der Regelkreis eingeschwungen ist.

6. Integrierte Schaltung mit einem D/A-Wandler (11), einem Komparator (13) und einem Verstärker (12), insbesondere ASIC, Mikrokontroller oder Hybridversion davon, die zur Durchführung eines Verfahrens nach einem der vorhergehenden Ansprüche ausgestaltet ist.

7. Betriebsgerät für Leuchtmittel,
aufweisend eine Schaltung nach Anspruch 6.

8. Beleuchtungssystem,
aufweisend mehrere Betriebsgeräte mit angeschlossenen Leuchtmitteln, darunter wenigstens ein Betriebsgerät nach Anspruch 7.

9. Schaltungsanordnung zum Dimmen eines Leuchtmittels (1) entsprechend - Sollwerte bildenden - digitalen Dimmwerten (D_{d}) durch digitale Regelung (7),
mit einem Komparator (13), dem die Dimmwerte und der Helligkeit des Leuchtmittels (1) entsprechende Istwerte (Ia) zugeführt werden, und der durch Vergleich eine Regelabweichung (x) ermittelt,
und mit einem digitalen Regler (7), dem die Regelabweichung zugeführt wird, und der daraus einen digitalen Stellwert (X_{d}) zur Steuerung des Leuchtmittels (3) erzeugt,
wobei dem Komparator (13) ein D/A-Wandler (11) vorgeschaltet ist, der die digitalen Dimmwerte (D_{d}) in analoge Dimmwerte (Dₐ) umwandelt, und wobei der Komparator (13) analog arbeitet und eine analoge Regelabweichung (xₐ) ermittelt, und
wobei dem Komparator (13) ein A/D-Wandler (14) nachgeschaltet ist, der die analoge Regelabweichung (xₐ) in eine digitale Regelabweichung (x_{d}) umwandelt, welche dann dem digitalen Regler (7) zugeführt wird,
**dadurch gekennzeichnet,**
**dass** der Helligkeit des Leuchtmittels (1) entsprechende Istwerte (Iₐ) zunächst in einem Verstärker (12) verstärkt (V) werden, bevor sie dem Komparator (13) zugeführt werden.

10. Schaltungsanordnung nach Anspruch 9,
**dadurch gekennzeichnet,**
**dass** der dem Komparator (13) vor geschaltete D/A-Wandler (11) so ausgebildet ist, dass die digitalen Dimmwerte (D_{d}) bei der Umwandlung in analoge Dimmwerte (Dₐ) modifiziert wird, derart, dass die Dimmwert-Schritte bei hohen Dimmwerten größer sind als bei geringen Dimmwerten sind.

11. Schaltungsanordnung nach Anspruch 10,
**dadurch gekennzeichnet,**
**dass** der Verstärkungsgrad (V) bei Erreichen eines bestimmten Betriebszustandes um einen Faktor reduziert wird,
und **dass** zur Kompensation der Reduzierung bei der D/A-Umwandlung eine Multiplikation mit diesem Faktor vorgenommen wird.

12. Schaltungsanordnung nach Anspruch 10 oder 11,
**dadurch gekennzeichnet,**
**dass** der Faktor 2 oder ein ganzzahliges Vielfaches davon ist.

13. Schaltungsanordnung nach Anspruch 11 oder 12,
**dadurch gekennzeichnet,**
**dass** der bestimmte Betriebszustand das Erreichen eines Extremwertes des A/D-Wandlers (14) und/oder - falls das Leuchtmittel (1) eine Gasentladungslampe ist - das Zünden der Gasentladungslampe ist, letzteres ggf. mit Verzögerung bis der Regelkreis eingeschwungen ist.

14. Betriebsgerät für Leuchtmittel,
aufweisend eine Schaltungsanordnung nach Anspruch 13.

15. Beleuchtungssystem,
aufweisend mehrere Betriebsgeräte mit angeschlossenen Leuchtmitteln, darunter wenigstens ein Betriebsgerät nach Anspruch 13.

16. Beleuchtungssystem nach Anspruch 15,
wobei die Betriebsgeräte mit einem Bus verbunden sind, über den die Dimm-Sollwerte vorzugsweise von einer Zentralen, einer Benutzerschnittstelle oder einem anderem Busteilnehmer aus übermittelt werden.

## Claims

1. A method for dimming an illuminant (1) according to - target value forming - digital dimming values (D_{d}) by digital control (7),
wherein
the digital dimming values (D_{d}) are initially converted into analog dimming values (Dₐ), wherein the analog dimming values (Dₐ) are compared (13) with corresponding analog actual values (Iₐ) and that an analog control deviation (xₐ) is determined therefrom,
and wherein the analog control deviation (xₐ) is converted into a digital control deviation (x_{d}) for performing the digital control (7),
**characterized in**
**that** the analog actual values (Iₐ) are amplified (V) before the comparison with the analog dimming values (Dₐ).

2. A method according to Claim 1,
**characterized in**
**that** the digital dimming values (D_{d}) are modified upon conversion into analog dimming values (Dₐ), such that the dimming value steps are greater at high dimming values than at low dimming values.

3. A method according to Claim 1 or 2,
**characterized in**
**that** upon reaching of a certain operating state the degree of amplification (V) is reduced by a factor,
and **that** to compensate for the reduction during the D/A conversion a multiplication is carried out by said factor.

4. A method according to Claim 3,
**characterized in**
**that** the factor corresponds to a binary combination, therefore 2, 4, 8, etc.

5. A method according to Claim 3 or 4,
**characterized in**
**that** the certain operating state is the reaching of an extreme value during the A/D conversion and/or - if the illuminant (1) is a gas discharge lamp - the ignition of the gas discharge lamp, the latter, if applicable, with a delay until the control circuit has settled.

6. An integrated circuit with a D/A converter (11), a comparator (13) and an amplifier (12), in particular, an ASIC, micro-controller or hybrid version thereof, which is designed for the implementation of a method according to any one of the preceding claims.

7. An operating device for an illuminant,
having a circuit according to Claim 6.

8. An illumination system,
having a plurality of operating devices with connected illuminants, including at least one operating device according to Claim 7.

9. A circuit arrangement for dimming an illuminant (1) according to - target value forming - digital dimming values (D_{d}) by digital control (7),
having a comparator (13), to which the dimming values and actual values (Iₐ) corresponding to the brightness of the illuminant (1) are supplied, and which by comparison determines a control deviation (x),
and with a digital regulator (7), to which the control deviation is supplied and which generates therefrom a digital control value (X_{d}) for controlling the illuminant (3).
wherein a D/A-converter (11) is arranged upstream of the comparator (13), which D/A converter converts the digital dimming values (D_{d}) into analog dimming values (Dₐ),
and wherein the comparator (13) works in an analog domain and ascertains an analog control deviation (xₐ), and
wherein an A/D converter (14) is arranged downstream of the comparator (13), which A/D converter converts the analog control deviation (xₐ) into a digital control deviation (x_{d}), which is then supplied to the digital regulator (7),
**characterized in**
**that** actual values (Iₐ) corresponding to the brightness of the illuminant (1) are initially amplified (V) in an amplifier (12), before they are supplied to the comparator (13).

10. A circuit arrangement according to Claim 9,
**characterized in**
**that** the D/A converter (11) arranged upstream of the comparator (13) is designed such that the digital dimming values (D_{d}) are modified upon conversion into analog dimming values (Dₐ) in such a manner that the dimming value steps are greater at high dimming values than at low dimming values.

11. A circuit arrangement according to Claim 10,
**characterized in**
**that** the degree of amplification (V) upon reaching of a certain operating state is reduced by a factor,
and **that** to compensate for the reduction during the D/A conversion a multiplication is carried out by said factor.

12. A circuit arrangement according to Claim 10 or 11,
**characterized in**
**that** the factor is 2 or an integral multiple thereof.

13. A circuit arrangement according to Claim 11 or 12,
**characterized in**
**that** the certain operating state is the reaching of an extreme value of the A/D converter (14) and/or - if the illuminant (1) is a gas discharge lamp - the ignition of the gas discharge lamp, the latter, if applicable, with a delay until the control circuit has settled.

14. An operating device for an illuminant,
having a circuit arrangement according to Claim 13.

15. An illumination system,
having a plurality of operating devices with connected illuminants, including at least one operating device according to Claim 13.

16. An illumination system according to Claim 15,
wherein the operating devices are connected with a bus, via which the dimming target values are preferably transmitted from a center, a user interface or another bus participant.

## Revendications

1. Procédé destiné à la gradation d'un moyen d'éclairage (1) conformément à des valeurs de gradation (D_{d}) numériques - formant des valeurs de consigne - par régulation numérique (7),
les valeurs de gradation (D_{d}) numériques étant d'abord converties en valeurs de gradation (Dₐ) analogiques,
les valeurs de gradation (Dₐ) analogiques étant comparées à des valeurs effectives (Ia) analogiques correspondantes (13), et un écart de régulation (Xₐ) analogique étant déterminé à partir de cela,
l'écart de régulation (Xₐ) analogique étant converti en un écart de régulation (X_{d}) numérique pour la réalisation de la régulation numérique (7),
**caractérisé en ce que**
les valeurs effectives (Ia) analogiques sont amplifiées (V) avant la comparaison avec les valeurs de gradation (Dₐ) analogiques.

2. Procédé selon la revendication 1,
**caractérisé en ce que**
les valeurs de gradation (D_{d}) numériques sont, lors de la conversion en valeurs de gradation (Dₐ) analogiques, modifiées de telle sorte que les pas de valeurs de gradation sont plus grands en présence de valeurs de gradation élevées qu'en présence de valeurs de gradation faibles.

3. Procédé selon la revendication 1 ou 2,
**caractérisé en ce que**
le taux d'amplification (V) est réduit d'un facteur lorsqu'un état de fonctionnement défini est atteint,
et **en ce qu'**une multiplication par ce facteur est effectuée pour la compensation de la réduction lors de la conversion N/A.

4. Procédé selon la revendication 3,
**caractérisé en ce que**
le facteur correspond à une combinaison binaire, donc à 2, 4, 8, etc.

5. Procédé selon la revendication 3 ou 4,
**caractérisé en ce que**
l'état de fonctionnement défini est l'obtention d'une valeur extrême lors de la conversion A/N et/ou - si le moyen d'éclairage (1) est une lampe à décharge de gaz - l'allumage de la lampe à décharge de gaz, ce dernier éventuellement avec un retard jusqu'à ce que le circuit de régulation soit stabilisé.

6. Circuit intégré avec un convertisseur N/A (11), un comparateur (13) et un amplificateur (12), en particulier un ASIC, un microncontrôleur ou une version hybride de ceux-ci, qui est constitué pour la réalisation d'un procédé selon l'une des revendications précédentes.

7. Appareil de commande pour des moyens d'éclairage, présentant un circuit selon la revendication 6.

8. Système d'éclairage,
présentant plusieurs appareils de commande avec des moyens d'éclairage connectés, dont au moins un appareil de commande selon la revendication 7.

9. Agencement de circuit destiné à la gradation d'un moyen d'éclairage (1) conformément à des valeurs de gradation (D_{d}) numériques - formant des valeurs de consigne - par régulation numérique (7),
avec un comparateur (13), auquel sont conduites les valeurs de gradation et des valeurs effectives (Ia) correspondant à la luminosité du moyen d'éclairage (1), et qui détermine un écart de régulation (x) par comparaison,
et avec un régulateur numérique (7) auquel est conduit l'écart de régulation (x) et qui produit à partir de cela une valeur de réglage (X_{d}) numérique pour la commande du moyen d'éclairage (3),
un convertisseur N/A (11) étant monté en amont du comparateur (13) et convertissant les valeurs de gradation (D_{d}) numériques en valeurs de gradation (Dₐ) analogique,
et le comparateur (13) fonctionnant de façon analogique et déterminant un écart de régulation (Xₐ) analogique, et
un convertisseur A/N (14) étant monté en aval du comparateur (13) et convertissant l'écart de régulation (Xₐ) analogique en un écart de régulation (X_{d}) numérique qui est ensuite conduit à au régulateur numérique (7),
**caractérisé en ce que**
des valeurs effectives (Ia) correspondant à la luminosité du moyen d'éclairage (1) sont d'abord amplifiées (V) dans un amplificateur (12) avant d'être conduites au comparateur (13).

10. Agencement de circuit selon la revendication 9,
**caractérisé en ce que**
le convertisseur N/A (11) monté en amont du comparateur (13) est constitué de telle sorte que les valeurs de gradation (D_{d}) numériques sont, lors de la conversion en valeurs de gradation (Dₐ) analogiques, modifiées de telle sorte que les pas de valeurs de gradation sont plus grands en présence de valeurs de gradation élevées qu'en présence de valeurs de gradation faibles.

11. Agencement de circuit selon la revendication 10,
**caractérisé en ce que**
le taux d'amplification (V) est réduit d'un facteur lorsqu'un état de fonctionnement défini est atteint,
et **en ce qu'**une multiplication par ce facteur est effectuée pour la compensation de la réduction lors de la conversion N/A.

12. Agencement de circuit selon la revendication 10 ou 11,
**caractérisé en ce que**
le facteur est égal à 2 à ou à un multiple entier de 2.

13. Agencement de circuit selon la revendication 11 ou 12,
**caractérisé en ce que**
l'état de fonctionnement défini est l'obtention d'une valeur extrême du convertisseur A/N (14) et/ou - si le moyen d'éclairage (1) est une lampe à décharge de gaz - l'allumage de la lampe à décharge de gaz, ce dernier éventuellement avec un retard jusqu'à ce que le circuit de régulation soit stabilisé.

14. Appareil de commande pour moyens d'éclairage,
présentant un agencement de circuit selon la revendication
13.

15. Système d'éclairage,
présentant plusieurs appareils de commande avec des moyens d'éclairage connectés, dont au moins un appareil de commande selon la revendication 13.

16. Système d'éclairage selon la revendication 15,
les appareils de commande étant raccordés à un bus par le biais duquel les valeurs de consigne de gradation sont transmises de préférence à partir d'une centrale, d'une interface utilisateur ou d'un autre utilisateur du bus.
